# FASCICULE DE BREVET EUROPEEN

(11) **EP 4 627 355 B1**
(45) Date de publication et mention de la délivrance du brevet: **28.10.2026**
(21) Numéro de dépôt: 23825424.7
(22) Date de dépôt: 29.11.2023
(51) Int. Cl.: G01R 31/00, G01R 31/52, G01R 31/54

(54) **PROCÉDÉ DE DÉTECTION D'UN DÉFAUT ÉLECTRIQUE D'UN RÉSEAU DE CÂBLES D'UN HARNAIS ET DISPOSITIF ASSOCIÉ**
VERFAHREN ZUR ERKENNUNG EINES ELEKTRISCHEN FEHLERS IN EINEM KABELNETZWERK EINES KABELBAUMS UND ZUGEHÖRIGE VORRICHTUNG
METHOD FOR DETECTING AN ELECTRICAL FAULT IN A CABLE NETWORK OF A HARNESS AND ASSOCIATED DEVICE

(30) Priorité: 01.12.2022 FR 2212614
(43) Date de publication de la demande: 08.10.2025
(73) Titulaire: Safran Nacelles, 76700 Gonfreville-l'Orcher (FR)
(72) Inventeur: PEREIRA, David, 77550 Moissy-Cramayel (FR); DELESALLE, Thibault, 77550 Moissy-Cramayel (FR)
(74) Mandataire: Regimbeau
(86) Numéro de dépôt international: PCT/FR2023/051867
(87) Numéro de publication internationale: WO 2024/115857

(56) Documents cités:
- WO-A1-2022/162686
- US-A1- 2016 084 902
- US-A1- 2016 178 683

## Description

### DOMAINE DE L'INVENTION

L'invention concerne le domaine de la maintenance des systèmes embarqués d'un aéronef.

En particulier, l'invention concerne la maintenance d'un harnais électrique d'un aéronef.

### ETAT DE LA TECHNIQUE

Une turbomachine présente une direction principale s'étendant selon un axe longitudinal, et comporte typiquement, d'amont en aval dans le sens de l'écoulement des gaz, une soufflante et un corps primaire comportant une section de compression pouvant comprendre un compresseur basse pression, un compresseur haute pression, une chambre de combustion, et une section de turbine pouvant comprendre une turbine haute pression et une turbine basse pression. En particulier, les turbomachines dites à double corps comprenant un arbre basse pression et un arbre haute pression sont équipées de capteurs servant à mesurer le régime de rotation de l'arbre basse pression et le régime de rotation de l'arbre haute pression.

Un harnais électrique est un dispositif électrique qui véhicule des signaux électriques entre différents équipements. Dans le cas de la turbomachine équipée de calculateurs et de nombreux capteurs, des harnais électriques sont placés entre le calculateur et les capteurs de façon à véhiculer - vers le calculateur - les mesures effectuées par ces capteurs, par exemple les mesures effectuées sur les arbres basse pression et haute pression. Le harnais comprend un réseau de fils isolés électriquement et protégé des perturbations électromagnétiques extérieures par des dispositifs de blindage et de gaines isolantes et comprend entre différentes extrémités des terminaisons (connecteurs, cosses, etc.).

En cas de panne du harnais, deux types d'essais pour vérifier le bon fonctionnement du harnais électrique sont réalisés manuellement par un technicien. Une mesure de continuité électrique de chaque extrémité du harnais, pour s'assurer qu'il n'y a pas de fils coupés, et une mesure d'isolement sur tous les connecteurs du harnais pour s'assurer qu'il n'y a pas de court-circuit entre les fils ainsi qu'entre les fils et le blindage.

Or, ce procédé peut être long si le nombre de fils à tester est important. De plus, il existe un risque que le technicien chargé de la maintenance fasse une mauvaise manipulation ou qu'il oublie de tester un ou plusieurs fils.

Le document WO2022/162686 A1 divulgue un procédé de détection d'un défaut électrique dans un réseau de câbles selon l'état de l'art.

### EXPOSE DE L'INVENTION

Un but de l'invention est donc d'automatiser la détection de pannes d'un harnais afin d'améliorer la fiabilité et la vitesse d'exécution d'une opération de maintenance sur le harnais.

À cet effet, selon un premier aspect de l'invention, il est proposé un procédé de détection d'un défaut électrique dans un réseau de câbles reliant électriquement une première terminaison et une deuxième terminaison d'un harnais électrique d'un aéronef,
le procédé comprenant les étapes suivantes :
E1 : relier le réseau de câbles aux voies d'un premier multiplexeur et d'un deuxième multiplexeur d'un dispositif de détection d'un défaut électrique du harnais ;
E2 : alimenter une anode d'une première diode du dispositif à un premier potentiel et une anode d'une seconde diode du dispositif à un second potentiel différent du premier potentiel ;
le procédé comprenant, à chaque itération d'une pluralité d'itérations, la réalisation des étapes suivantes:
   E41 : sélectionner une première adresse du premier multiplexeur et une deuxième adresse du deuxième multiplexeur ;
   E42 : calculer une différence de potentiel entre une cathode de la première diode et une cathode de la deuxième diode ; et
   E43 : déduire de la différence de potentiel l'existence d'un défaut électrique dans le réseau de câbles.

Ainsi, un tel procédé octroie au technicien un gain de temps sur la recherche de pannes. On estime le temps économisé par le technicien entre 25% à 92% de la durée d'une opération de maintenance sans mettre en oeuvre le procédé, selon le nombre de fils testés.

Un meilleur diagnostic de l'état de fonctionnement des harnais électriques est également possible permettant de réduire les coûts de maintenance liés à un renvoi d'un harnais électrique en bon état de fonctionnement au fournisseur.

Il peut être prévu en outre une étape E3 de configuration des adresses des voies des premier et deuxième multiplexeurs, chaque adresse correspondant à un fil distinct du réseau de câbles.

Il peut être prévu en outre une étape E21 dans laquelle des fils du réseau de câbles sont reliés électriquement à un unique nœud.

Il peut être prévu en outre une étape E22 de sélection d'un mode de détection du dispositif, par exemple un mode de détection de courts-circuits et/ou un mode de détection d'un circuit ouvert.

Il peut être prévu que les voies des multiplexeurs sont configurées en chargeant un plan électrique du harnais enregistré dans une base de données.

Il peut être prévu en outre une étape E421 d'enregistrement des adresses et de la différence de potentiel.

Il peut être prévu que la pluralité d'itérations est au moins égale au nombre de combinaisons possibles d'une voie du premier multiplexeur avec une voie du deuxième multiplexeur.

Il peut être prévu que les fils identifiés en circuit ouvert et/ou en court-circuit sont affichés, par exemple sur un schéma électrique simplifié du harnais électrique.

Il peut être prévu que les fils identifiés en circuit ouvert et/ou en court-circuit sont enregistrés, par exemple dans un fichier.

Selon un deuxième aspect de l'invention, il est proposé un dispositif de détection d'un défaut électrique dans un réseau de câbles reliant électriquement une première terminaison et une deuxième terminaison d'un harnais électrique d'un aéronef comprenant :
- une interface de connexion configurée pour connecter le réseau de câbles au dispositif de détection ;
- un premier multiplexeur et un deuxième multiplexeur configurés pour être reliés électriquement au réseau de câbles ;
- une unité de traitement comprenant une première entrée et une deuxième entrée, la première entrée et la deuxième entrée étant configurées pour être reliées électriquement au premier multiplexeur et au deuxième multiplexeur respectivement ;
- une première diode comprenant une première anode configurée pour être reliée à une source de tension à un premier potentiel et une première cathode configurée pour être reliée électriquement à une sortie du premier multiplexeur et la première entrée de l'unité de traitement ; et
- une deuxième diode comprenant une deuxième anode configurée pour être reliée à une source de tension à un deuxième potentiel et une deuxième cathode configurée pour être reliée électriquement à une sortie du deuxième multiplexeur et la deuxième entrée de l'unité de traitement, le deuxième potentiel étant différent du premier potentiel ;
l'unité de traitement étant configurée pour :
- sélectionner une première adresse du premier multiplexeur et une deuxième adresse du deuxième multiplexeur ;
- calculer une différence de potentiel entre la première cathode et la deuxième cathode ; et
- déduire de la différence de potentiel l'existence d'un défaut électrique dans le réseau de câbles.

Il peut être prévu que le dispositif comprend en outre un moyen d'interconnexion de fils du réseau de câbles à un unique nœud.

Il peut être prévu que la source de tension est une source locale ou dérivée d'un réseau électrique de l'aéronef.

Selon un troisième aspect de l'invention, il est proposé un produit programme d'ordinateur comprenant des instructions qui, lorsque le programme est exécuté sur une unité de traitement d'un dispositif conforme au deuxième aspect, conduisent celle-ci à mettre en œuvre les étapes E41 à E43 du procédé selon le premier aspect.

Selon un quatrième aspect du présent exposé, Il est proposé un moyen de stockage lisible par un ordinateur, sur lequel est enregistré le produit programme d'ordinateur selon le troisième aspect.

### DESCRIPTION DES FIGURES

Nous allons maintenant présenter un mode de réalisation de l'invention à titre d'exemple non-limitatif à l'appui des dessins sur lesquels :
- la figure 1 est un schéma d'une turbomachine d'un aéronef comprenant un harnais électrique ;
- la figure 2 est un schéma d'une partie d'un harnais électrique d'un aéronef ;
- la figure 3 est un schéma d'un dispositif de détection selon l'invention ;
- la figure 4 est un algorigramme présentant les étapes d'un mode de mise en œuvre du procédé selon l'invention ;
- la figure 5 est un schéma électrique simplifié du dispositif de la figure 3 connecté à un harnais ;
- la figure 6 est un schéma électrique simplifié du dispositif de la figure 3 relié électriquement à un harnais comprenant des fils en court-circuit ;
- la figure 7 est un schéma électrique équivalent de la figure 6 ;
- la figure 8 est un schéma électrique simplifié du dispositif de la figure 3 relié électriquement à un harnais dans lequel les fils sont interconnectés ;
- la figure 9 est un schéma électrique équivalent de la figure 8 ; et
- la figure 10 est un schéma électrique simplifié du dispositif de la figure 3 relié électriquement à un harnais comprenant des fils en circuit ouvert.

Sur l'ensemble des figures, les éléments similaires portent des références identiques.

### DESCRIPTION DETAILLE DE L'INVENTION

Une turbomachine 10 présente une direction principale s'étendant selon un axe longitudinal X, et comporte typiquement, d'amont en aval dans le sens de l'écoulement des gaz, une soufflante 102, un corps primaire comportant une section de compression pouvant comprendre un compresseur basse pression 103 ainsi qu'un compresseur haute pression 104, une chambre de combustion 105, et une section de turbine pouvant comprendre une turbine haute pression 106 ainsi qu'une turbine basse pression 107. Dans un mode de réalisation, la soufflante 102 peut être carénée et être logée dans un carter de rétention et comprend une nacelle 101 définissant une enveloppe aérodynamique du moteur. En variante, la soufflante peut être non carénée. Le flux d'air entrant dans la turbomachine 10 se divise en un flux primaire configuré pour traverser le corps primaire et un flux secondaire qui contourne le corps primaire et est comprimé par la soufflante 102.

En outre, la turbomachine 10 peut être carénée et comprendre plus de deux corps.

La turbomachine 10 comprend au moins deux arbres d'entrainement, typiquement un arbre haute pression 109 et un arbre basse pression 108.

L'arbre haute pression 109 est raccordé à la turbine haute pression 106 et est configuré pour entraîner le compresseur haute pression 104.

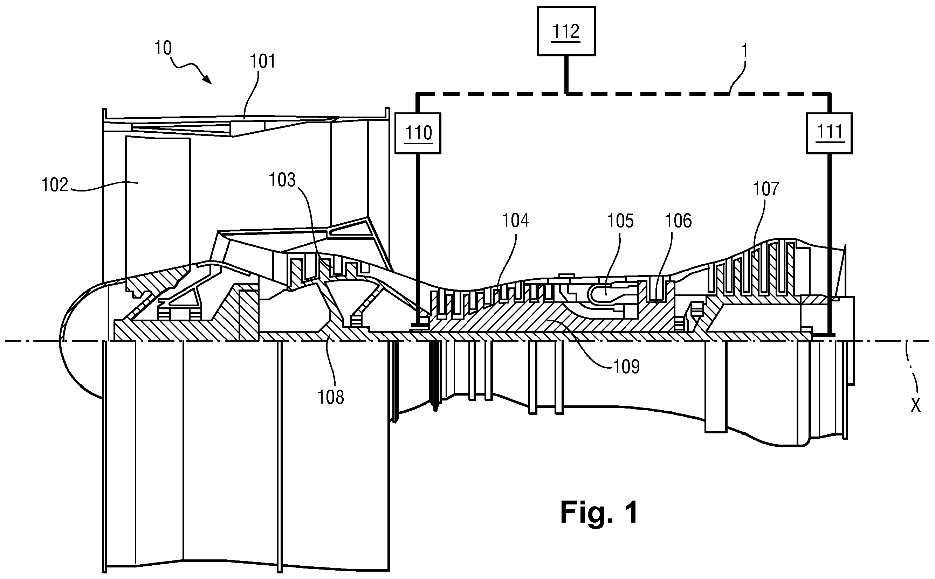

L'arbre basse pression 108 est raccordé à la turbine basse pression 107 et est configuré pour entrainer le compresseur basse pression 103. L'arbre basse pression 108 entraine en outre la soufflante 102, soit directement par la turbine basse pression, soit par l'intermédiaire d'un mécanisme de réduction pouvant comprendre un réducteur épicycloïdal du type planétaire ou en étoile (voir figure 1).

L'invention s'applique également aux turbomachines comprenant un troisième arbre raccordé à une turbine intermédiaire s'étendant entre la turbine haute pression 106 et la turbine basse pression 107. La turbine intermédiaire entraine le compresseur basse pression 103. La soufflante 102 est entrainée par la turbine basse pression 107.

Dans la présente demande, l'amont et l'aval sont définis par rapport au sens d'écoulement normal du gaz dans la turbomachine 10. Ainsi, l'axe X de la turbomachine 10 correspond à l'axe de rotation de ses parties rotor.

La turbomachine 10 comprend également deux capteurs de vitesse 110 et 111 configurés pour mesurer respectivement la vitesse de rotation de l'arbre haute pression 109 et de l'arbre basse pression 108, ainsi qu'un calculateur 112 relié électriquement aux capteurs 110, 111.

La turbomachine 10 comprend en outre un harnais électrique 1 comprenant une première terminaison et une deuxième terminaison à ses extrémités configurées pour relier électriquement les capteurs 110 et 111, respectivement, au calculateur 112 dans la turbomachine 1 par un réseau de câbles, chaque câble comprenant un ou plusieurs fils. Les terminaisons peuvent comprendre des connecteurs ou des cosses.

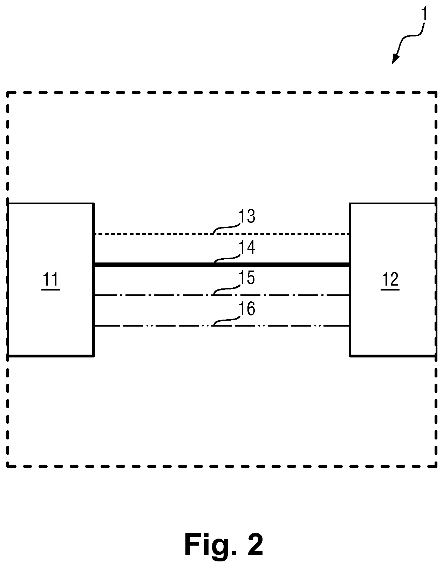

Par exemple, comme illustré en figure 2, quatre fils 13, 14 ,15, 16 forment une partie du réseau de câbles reliant électriquement la première terminaison comprenant un premier connecteur 11 et la deuxième terminaison comprenant un deuxième connecteur 12. Le réseau de câbles est isolé électriquement ainsi que des perturbations électromagnétiques extérieures par une gaine.

Or, la Demanderesse s'est aperçue que le harnais électrique 1 peut être sujet à des défauts électriques comme un court-circuit entre deux fils ou bien une rupture d'un fil difficiles à localiser. Ce défaut peut provenir avant son installation dans la turbomachine 100 ou bien lors de son utilisation.

Ainsi, pour détecter un défaut électrique, il est proposé un dispositif 2 pour détecter un défaut électrique dans le réseau de câbles reliant électriquement le premier connecteur 11 et le deuxième connecteur 12 du harnais 1.

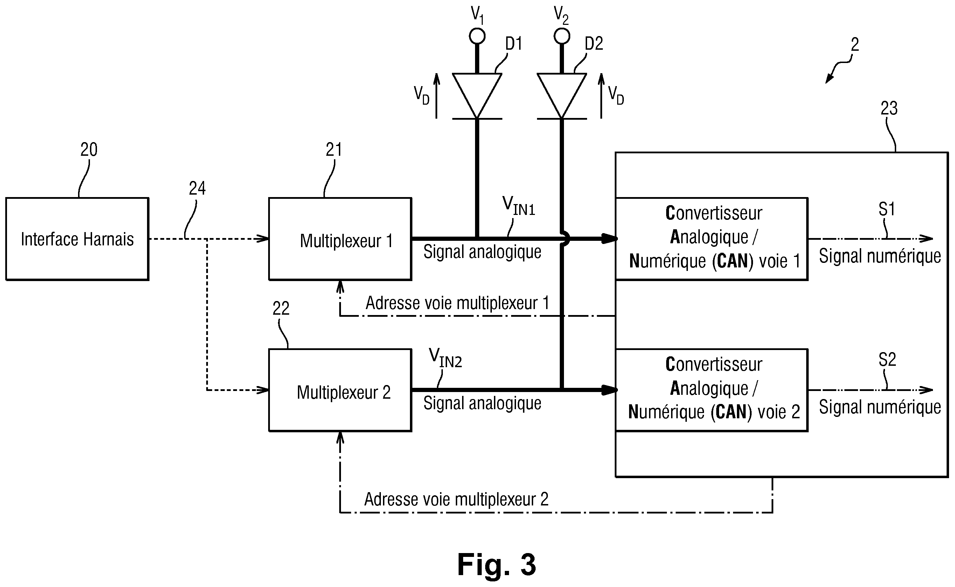

Le dispositif 2 de détection d'un défaut électrique dans un harnais électrique 1 est illustré à titre d'exemple non limitatif en figure 3. Le dispositif 2 comprend :
- une interface de connexion 20 (ou interface harnais) configurée pour connecter le réseau de câbles au dispositif de détection 2 ;
- un premier multiplexeur 21 et un deuxième multiplexeur 22 configurés pour être reliés électriquement au réseau de câbles ;
- une unité de traitement 23 comprenant une première entrée V_{IN1} et une deuxième entrée V_{IN2}, la première entrée V_{IN1} et la deuxième entrée V_{IN2} étant configurées pour être reliées électriquement au premier multiplexeur 21 et au deuxième multiplexeur 22 respectivement ;
- une première diode D1 comprenant une première anode A1 configurée pour être reliée à une source de tension V₁ à un premier potentiel et une première cathode C1 configurée pour être reliée électriquement à la sortie du premier multiplexeur 21 et la première entrée V_{IN1} de l'unité de traitement 23 ; et
- une deuxième diode D2 comprenant une deuxième anode A2 configurée pour être reliée à une source de tension V₂ à un deuxième potentiel et une deuxième cathode C2 configurée pour être reliée électriquement à la sortie du deuxième multiplexeur 22 et la deuxième entrée de l'unité de traitement 23, le deuxième potentiel V₂ étant différent du premier potentiel V₁.

L'unité de traitement 23 est configurée pour :
- sélectionner une première adresse du premier multiplexeur 21 et une deuxième adresse du deuxième multiplexeur 22 ;
- calculer une différence de potentiel entre la première cathode C1 et la deuxième cathode C2 ; et
- déduire de la différence de potentiel l'existence d'un défaut électrique dans le réseau de câbles.

Dans ce qui suit, l'invention est particulièrement décrite dans le cas d'un harnais électrique 1 d'une turbomachine 10. Ceci n'est cependant pas limitatif, l'invention s'appliquant à n'importe quel harnais convenant pour un aéronef.

Selon un mode de réalisation illustré en figure 3, l'interface de connexion 20 est configurée pour créer une liaison électrique 24 entre les fils 13, 14, 15, 16, par l'intermédiaire du second connecteur 12 du harnais 1 et des multiplexeurs 21, 22.

Selon un autre mode de réalisation, l'interface de connexion 20 peut être configurée pour créer une liaison électrique 24 directement entre les fils 13, 14 ,15, 16 et les multiplexeurs 21, 22. Ainsi, le dispositif de test 2 peut être connecté de façon universelle sur n'importe quel type de harnais électrique 1.

Les sorties de l'interface 20 sont connectées de façon identique à toutes les voies du premier multiplexeur 21 et du deuxième multiplexeur 22. Les adresses transmises aux multiplexeurs 21, 22 par l'unité de traitement 23 permettent de choisir indépendamment une première voie du premier multiplexeur 21 et une deuxième voie du deuxième multiplexeur 22 correspondant chacune à l'un des fils 13, 14 ,15, 16 à tester. Ainsi, les multiplexeurs 21, 22 peuvent sélectivement transmettre un signal analogique issu d'une seule voie connectée.

Les entrées analogiques V_{IN1} et V_{IN2} de l'unité de traitement 23 sont reliées électriquement respectivement aux sorties du multiplexeur 21 et 22. Un convertisseur analogique/numérique (CAN) est configuré pour convertir les signaux analogiques en des signaux numériques et l'unité de traitement 23 est configurée pour calculer une différence de potentiel entre les deux signaux analogiques. L'unité de traitement 23 est en outre configurée pour réaliser d'autres opérations mathématiques et/ou statistiques de sorte que des pannes récurrentes pour une même famille de harnais soient mises en évidence. Ainsi, l'identification des pannes est améliorée.

L'unité de traitement 23 comprend aussi deux sorties S1 et S2. Il est donc possible de visualiser les signaux en sortie de l'unité de traitement 23, par exemple sur un écran.

L'unité de commande 23 peut par exemple être un microcontrôleur, un FPGA, ou tout autre composant électronique équivalent.

La différence de potentiel imposée entre les cathodes C1, C2 des diodes D1, D2 permet de détecter un défaut. En effet, en cas de court-circuit entre deux fils du harnais 1, les deux cathodes C1, C2 sont reliées électriquement lorsque l'unité de traitement 23 sélectionne les deux voies en court-circuit. Dans le cas où par exemple la tension V₁ est supérieure à la tension V₂, la diode D1 est passante et la diode D2 est bloquée (le courant circule du potentiel le plus haut au potentiel le plus bas) imposant simultanément aux entrées analogiques V_{IN1}, V_{IN2} de l'unité de traitement 23 le potentiel de cathode de la diode D1. En l'espèce, la différence de potentiel entre les cathodes de D1 et D2 est de valeur nulle et permet donc la détection du court-circuit.

Dans le cas d'une détection d'un circuit ouvert, le dispositif peut comprendre un moyen d'interconnexion 24 de fils 13, 14, 15, 16 du réseau de câbles à un unique nœud imposant une différence de potentiel entre V_{IN1} et V_{IN2} nulle, sauf si l'un des fils 13, 14 ,15, 16 n'est plus interconnecté entre le premier connecteur 11 et le second connecteur 12.

Ainsi, un tel montage des deux diodes D1 et D2 du dispositif 2 présente l'avantage d'être un montage de détection économique, mais aussi d'être passif parce qu'il ne nécessite pas de commande des moyens de détection.

Le dispositif 2 est alimenté aux potentiels V₁ et V₂ respectivement aux anodes A1, A2 de chaque diode D1 et D2 par une source de tension pouvant être locale, par exemple une batterie ou un poste d'alimentation, ou dérivée d'un réseau électrique de l'aéronef.

Par exemple, le réseau électrique de l'aéronef est un réseau alternatif triphasé 115V/400Hz.

Ainsi, le dispositif 2 présente l'avantage d'être nomade. Il peut être utilisé de façon indifférente sur un harnais électrique 1 hors de sa zone d'installation, par exemple la turbomachine 10, ou bien dans sa zone d'installation (voir figure 1) en débranchant seulement un connecteur. Réduire le nombre de manipulations présente aussi l'intérêt de fiabiliser les opérations de maintenance sur un harnais endommagé.

### Procédé de détection d'un défaut électrique dans le harnais 1

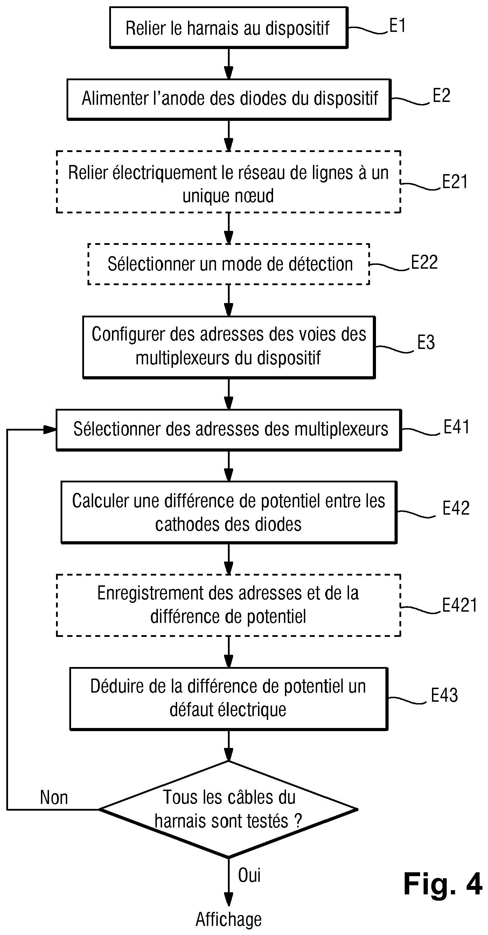

Le défaut électrique peut être un court-circuit ou un circuit ouvert dans le harnais électrique 1. Afin de détecter de tels défauts, le dispositif 2 peut être utilisé en mettant en oeuvre les étapes suivantes indiquées dans la figure 4.

Au cours d'une étape E1, le réseau de câbles est relié aux voies du premier multiplexeur 21 et du deuxième multiplexeur 22 du dispositif 2.

Au cours d'une étape E2, l'anode A1 de la première diode D1 du dispositif 2 est alimentée à un premier potentiel V1 et l'anode A2 d'une seconde diode D2 du dispositif 2 est alimentée à un second potentiel V2 différent du premier potentiel V1.

On peut prévoir en outre une étape E21, dans laquelle les fils 13, 14, 15, 16 du réseau de câbles sont reliés électriquement à un unique nœud, par exemple manuellement et/ou par un dispositif d'interconnexion 24 configuré pour la mise en oeuvre de l'étape présentant l'avantage de relier et/ou séparer le réseau de câbles de façon simple et rapide

À ce stade, le dispositif 2 est monté sur le réseau de câbles du harnais électrique 1, soit par l'interface de connexion 20 soit par tout autre moyen, et alimenté soit par le réseau électrique interne de la turbomachine 10, si l'intervention se fait sur un harnais électrique 1 monté sur la turbomachine 10, soit par une alimentation externe (batterie, réseau de distribution national, etc.), si l'intervention se fait sur un harnais électrique 1 démonté de la turbomachine 10.

Le dispositif 2 est donc prêt à l'emploi.

On peut également prévoir une étape E22, dans laquelle un mode de détection du dispositif 2 est sélectionné, par exemple un mode de détection de courts-circuits et/ou un mode de détection d'un circuit ouvert. Ainsi, sélectionner un mode de détection permet à l'unité de traitement 23 de réduire le nombre d'opérations à réaliser et donc augmenter la rapidité de calcul.

Au cours d'une étape E3, les adresses des voies des premier et deuxième multiplexeurs 21, 22 sont configurées, chaque adresse correspondant à un fil 13, 14,15, 16 distinct.

Lors de la configuration des adresses, un plan électrique du harnais 1 testé est chargé depuis une base de données du dispositif. Ainsi, l'association des voies des multiplexeurs 21, 22 et les fils 13, 14 ,15, 16 du harnais 1 correspond à la réalité du harnais 1 testé.

À chaque itération d'une pluralité d'itérations, les étapes suivantes sont réalisées.

La pluralité d'itérations peut par exemple être au moins égale au nombre de combinaisons possibles d'une voie du premier multiplexeur 21 avec une voie du deuxième multiplexeur 22.

La pluralité d'itérations peut être diminuée en testant, dans un premier temps, seulement les combinaisons possibles d'une voie du premier multiplexeur 21 avec une voie du deuxième multiplexeur 22 si ces voies correspondent aux fils les plus proches.

Au cours des étapes E41 et E42, une première adresse du premier multiplexeur 21 et une deuxième adresse du deuxième multiplexeur 22 sont sélectionnées pour ensuite calculer une différence de potentiel entre la cathode C1 de la première diode D1 et la cathode C2 de la deuxième diode D2.

On peut prévoir aussi une étape E421 dans laquelle les adresses des voies testées et la différence de potentiel calculée pour ces voies sont enregistrées.

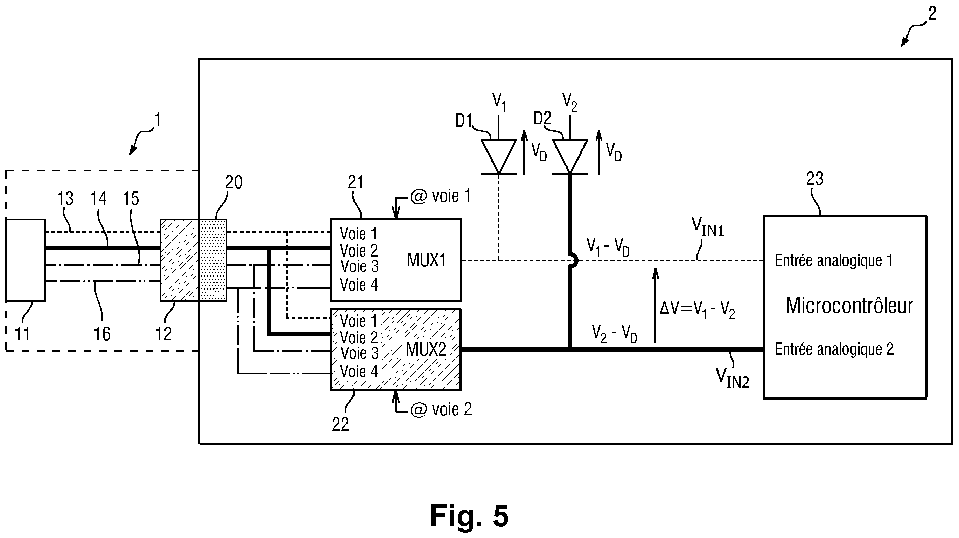

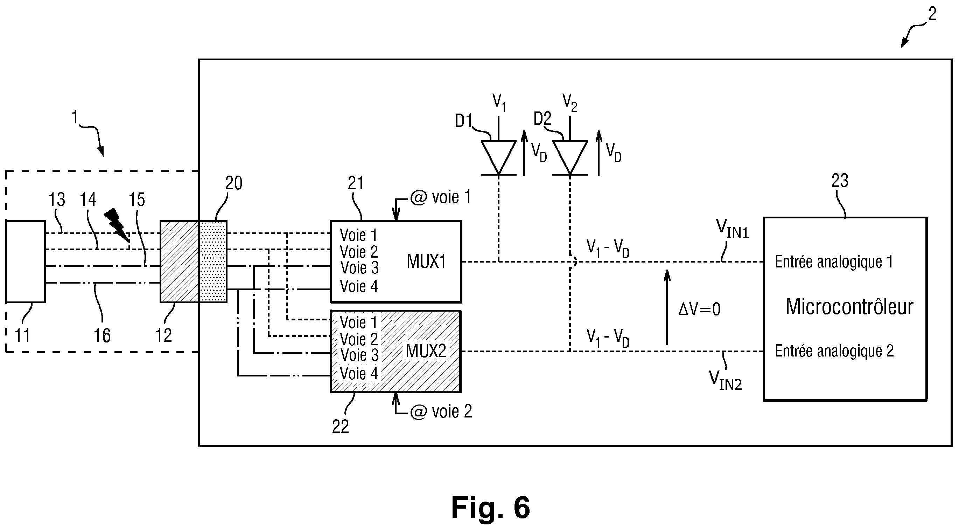

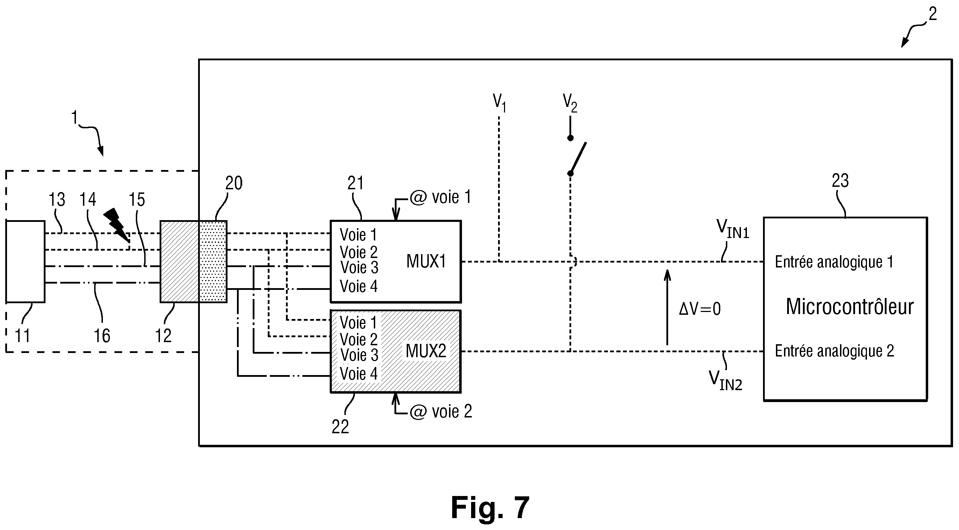

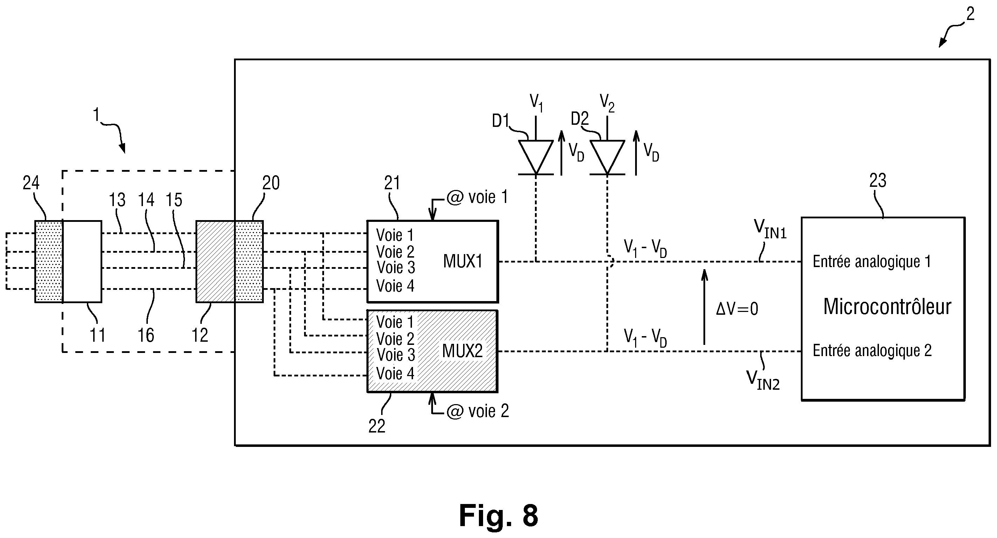

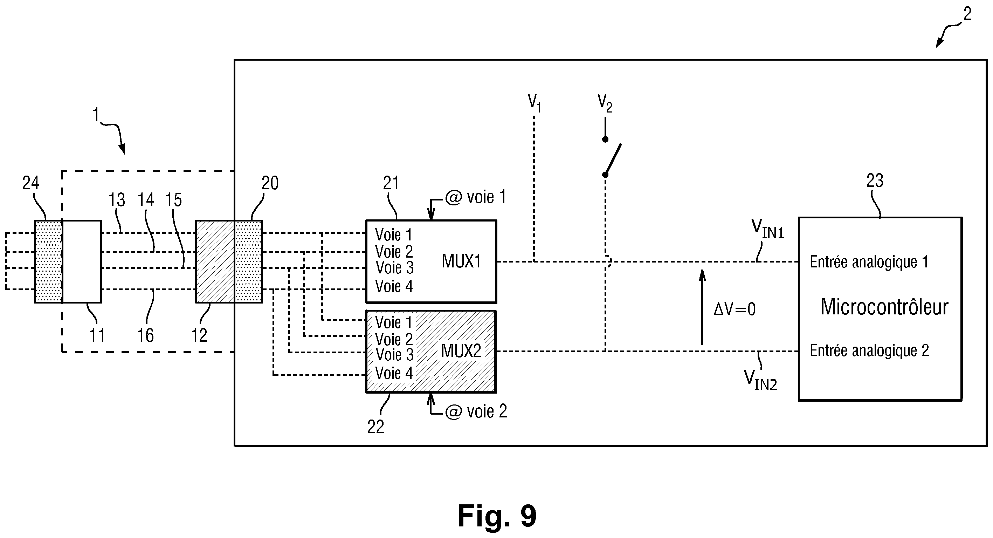

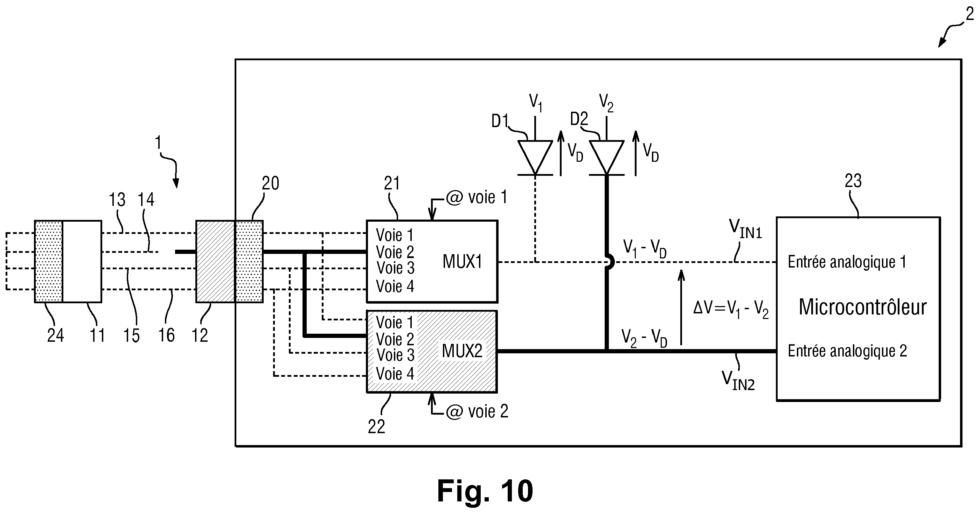

Puis, au cours d'une étape E43 l'existence d'un défaut électrique dans le réseau de câbles est déduite de la différence de potentiel. Les exemples suivants, illustrés aux figures 5 à 10, détaillent les différents défauts pouvant être déduits de la différence de potentiel :
- le réseau de câbles ne présente pas de court-circuit (figure 5) : la différence de potentiel est non nulle peu importe le fil testé. Il est donc possible d'en déduire l'absence de court-circuit dans le harnais 1 ;
- les fils 13, 14, 15, 16 du réseau de câbles sont reliés électriquement à un unique nœud et ne présente pas de circuit ouvert (figure 8 et 9) : la différence de potentiel est nulle peu importe le fil testé. Il est donc possible d'en déduire l'absence de circuit ouvert dans le harnais 1 ;
- le réseau de câbles présente un court-circuit entre les fils 13 et 14 (figures 6 et 7) : la différence de potentiel est nulle lorsque les adresses des voies correspondantes sont sélectionnées. Il est donc possible d'en déduire la présence d'un court-circuit dans le harnais 1 ;
- les fils 13, 14, 15, 16 du réseau de câbles sont reliés électriquement à un unique noeud et le réseau de câbles présente un circuit ouvert entre les fils 13 et 14 (figure 10) la différence de potentiel est non-nulle lorsque les adresses des voies correspondantes sont sélectionnées. Il est donc possible d'en déduire la présence d'un circuit ouvert dans le harnais 1 puis l'adresse du fil endommagé lorsque la différence de potentiel est calculée pour les autres combinaisons de voies.

Le cas échéant, les fils 13, 14, 15, 16 identifiés en circuit ouvert et/ou en court-circuit peuvent être affichés, par exemple sur un schéma électrique simplifié du harnais électrique 1.

Les fils (13, 14, 15, 16) identifiés en circuit ouvert et/ou en court-circuit peuvent aussi être enregistrés, par exemple dans un fichier configuré pour un archivage ou un post-traitement pour améliorer l'identification des causes des pannes, ou bien pour tracer un historique des pannes récurrentes afin d'en déduire une évolution du comportement du harnais lorsqu'il est en service.

## Revendications

1. Procédé de détection d'un défaut électrique dans un réseau de câbles reliant électriquement une première terminaison (11) et une deuxième terminaison (12) d'un harnais électrique (1) d'un aéronef,
le procédé comprenant les étapes suivantes :
E1 : relier le réseau de câbles aux voies d'un premier multiplexeur (21) et d'un deuxième multiplexeur(22) d'un dispositif (2) de détection d'un défaut électrique du harnais (1) ;
le procédé étant **caractérisé en ce qu'**il comprend en outre les étapes suivantes:
E2 : alimenter une anode (A1) d'une première diode (D1) du dispositif à un premier potentiel (V1) et une anode (A2) d'une seconde diode (D2) du dispositif (2) à un second potentiel (V2) différent du premier potentiel (V1) ;
le procédé comprenant, à chaque itération d'une pluralité d'itérations, la réalisation des étapes suivantes:
E41 : sélectionner une première adresse du premier multiplexeur (21) et une deuxième adresse du deuxième multiplexeur (22) ;
E42 : calculer une différence de potentiel entre une cathode (C1) de la première diode (D1) et une cathode (C2) de la deuxième diode (D2) ; et
E43 : déduire de la différence de potentiel l'existence d'un défaut électrique dans le réseau de câbles.

2. Procédé selon la revendication 1, comprenant en outre une étape E3 dans laquelle les adresses des voies des premier et deuxième multiplexeurs (21, 22) sont configurées, chaque adresse correspondant à un fil (13, 14, 15, 16) distinct du réseau de câbles.

3. Procédé selon l'une des revendications 1 et 2, comprenant en outre une étape E21 dans laquelle des fils (13, 14, 15, 16) du réseau de câbles sont reliés électriquement à un unique nœud.

4. Procédé selon l'une des revendications 1 à 3, comprenant en outre une étape E22 de sélection d'un mode de détection du dispositif (2), par exemple un mode de détection de courts-circuits et/ou un mode de détection d'un circuit ouvert.

5. Procédé selon l'une des revendications 1 à 4, dans lequel les voies des multiplexeurs (21, 22) sont configurées en chargeant un plan électrique du harnais (1) enregistré dans une base de données.

6. Procédé de détection selon l'une des revendications 1 à 5, comprenant en outre une étape E421 d'enregistrement des adresses et de la différence de potentiel.

7. Procédé selon l'une des revendications 1 à 6, dans lequel la pluralité d'itérations est au moins égale au nombre de combinaisons possibles d'une voie du premier multiplexeur (21) avec une voie du deuxième multiplexeur (22).

8. Procédé selon l'une des revendications 1 à 7, dans lequel les fils (13, 14, 15, 16) identifiés en circuit ouvert et/ou en court-circuit sont affichés, par exemple sur un schéma électrique simplifié du harnais électrique (1).

9. Procédé selon l'une des revendications 1 à 8, dans lequel les fils (13, 14, 15, 16) identifiés en circuit ouvert et/ou en court-circuit sont enregistrés, par exemple dans un fichier.

10. Dispositif (2) de détection d'un défaut électrique dans un réseau de câbles reliant électriquement une première terminaison (11) et une deuxième terminaison (12) d'un harnais électrique (1) d'un aéronef comprenant :
- une interface de connexion (20) configurée pour connecter le réseau de câbles au dispositif (2) de détection ;
- un premier multiplexeur (21) et un deuxième multiplexeur (22) configurés pour être reliés électriquement au réseau de câbles ;
- une unité de traitement (23) comprenant une première entrée et une deuxième entrée, la première entrée et la deuxième entrée étant configurées pour être reliées électriquement au premier multiplexeur (21) et au deuxième multiplexeur (22) respectivement ;
le dispositif étant **caractérisé en ce qu'**il comprend:
- une première diode (D1) comprenant une première anode (A1) configurée pour être reliée à une source de tension à un premier potentiel (V1) et une première cathode (C1) configurée pour être reliée électriquement à une sortie du premier multiplexeur (21) et la première entrée de l'unité de traitement (23) ; et
- une deuxième diode (D2) comprenant une deuxième anode (A2) configurée pour être reliée à une source de tension à un deuxième potentiel (V2) et une deuxième cathode (C2) configurée pour être reliée électriquement à une sortie du deuxième multiplexeur (22) et la deuxième entrée de l'unité de traitement (23), le deuxième potentiel (V2) étant différent du premier potentiel (V1) ;
l'unité de traitement (23) étant configurée pour :
- sélectionner une première adresse du premier multiplexeur (21) et une deuxième adresse du deuxième multiplexeur (22) ;
- calculer une différence de potentiel entre la première cathode (C1) et la deuxième cathode (C2) ; et
- déduire de la différence de potentiel l'existence d'un défaut électrique dans le réseau de câbles.

11. Dispositif (2) de détection selon la revendication 10, comprenant en outre un moyen d'interconnexion (24) de fils (13, 14, 15, 16) du réseau de câbles à un unique nœud.

12. Dispositif (2) de détection selon l'une des revendications 10 et 11, dans lequel la source de tension est une source locale ou dérivée d'un réseau électrique de l'aéronef.

13. Produit programme d'ordinateur comprenant des instructions qui, lorsque le programme est exécuté sur une unité de traitement (23) d'un dispositif (2) conforme à l'une des revendications 10 à 12, conduisent celle-ci à mettre en œuvre les étapes E41 à E43 du procédé selon l'une de revendications 1 à 9.

14. Moyen de stockage lisible par un ordinateur, sur lequel est enregistré le produit programme d'ordinateur selon la revendication 13.

## Patentansprüche

1. Verfahren zur Erkennung eines elektrischen Fehlers in einem Kabelnetz, das eine erste Endung (11) und eine zweite Endung (12) eines elektrischen Kabelbaums (1) eines Luftfahrzeugs elektrisch verbindet, wobei das Verfahren die folgenden Schritte umfasst:
E1: Verbinden des Kabelnetzes mit den Kanälen eines ersten Multiplexers (21) und eines zweiten Multiplexers (22) einer Vorrichtung (2) zur Erkennung eines elektrischen Fehlers des Kabelbaums (1);
wobei das Verfahren **dadurch gekennzeichnet ist, dass** es ferner die folgenden Schritte umfasst:
E2: Versorgen einer Anode (A1) einer ersten Diode (D1) der Vorrichtung mit einem ersten Potenzial (V1) und einer Anode (A2) einer zweiten Diode (D2) der Vorrichtung (2) mit einem zweiten Potenzial (V2), das von dem ersten Potenzial (V1) verschieden ist;
wobei das Verfahren bei jeder Iteration einer Vielzahl von Iterationen die Durchführung der folgenden Schritte umfasst:
E41: Auswählen einer ersten Adresse des ersten Multiplexers (21) und einer zweiten Adresse des zweiten Multiplexers (22);
E42: Berechnen einer Potenzialdifferenz zwischen einer Kathode (C1) der ersten Diode (D1) und einer Kathode (C2) der zweiten Diode (D2); und
E43: Ableiten des Vorliegens eines elektrischen Fehlers in dem Kabelnetz aus der Potenzialdifferenz.

2. Verfahren nach Anspruch 1, ferner umfassend einen Schritt E3, in dem die Adressen der Kanäle des ersten und des zweiten Multiplexers (21, 22) konfiguriert werden, wobei jede Adresse einem verschiedenen Draht (13, 14, 15, 16) des Kabelnetzes entspricht.

3. Verfahren nach einem der Ansprüche 1 und 2, ferner umfassend einen Schritt E21, in dem Drähte (13, 14, 15, 16) des Kabelnetzes mit einem einzigen Knoten elektrisch verbunden werden.

4. Verfahren nach einem der Ansprüche 1 bis 3, ferner umfassend einen Schritt E22 des Auswählens eines Erkennungsmodus der Vorrichtung (2), beispielsweise eines Kurzschluss-Erkennungsmodus und/oder eines Open-Circuit-Erkennungsmodus.

5. Verfahren nach einem der Ansprüche 1 bis 4, wobei die Kanäle der Multiplexer (21, 22) durch Laden eines in einer Datenbank gespeicherten elektrischen Schaltplans des Kabelbaums (1) konfiguriert werden.

6. Erkennungsverfahren nach einem der Ansprüche 1 bis 5, ferner umfassend einen Schritt E421 des Aufzeichnens der Adressen und der Potenzialdifferenz.

7. Verfahren nach einem der Ansprüche 1 bis 6, wobei die Vielzahl von Iterationen mindestens gleich der Anzahl der möglichen Kombinationen eines Kanals des ersten Multiplexers (21) mit einem Kanal des zweiten Multiplexers (22) ist.

8. Verfahren nach einem der Ansprüche 1 bis 7, wobei die als Open Circuit und/oder Kurzschluss identifizierten Drähte (13, 14, 15, 16) angezeigt werden, beispielsweise auf einem vereinfachten elektrischen Schaltplan des elektrischen Kabelbaums (1).

9. Verfahren nach einem der Ansprüche 1 bis 8, wobei die als Open Circuit und/oder Kurzschluss identifizierten Drähte (13, 14, 15, 16) aufgezeichnet werden, beispielsweise in einer Datei.

10. Vorrichtung (2) zur Erkennung eines elektrischen Fehlers in einem Kabelnetz, das eine erste Endung (11) und eine zweite Endung (12) eines elektrischen Kabelbaums (1) eines Luftfahrzeugs elektrisch verbindet, umfassend:
- eine Verbindungsschnittstelle (20), die so konfiguriert ist, dass sie das Kabelnetz mit der Erkennungsvorrichtung (2) verbindet;
- einen ersten Multiplexer (21) und einen zweiten Multiplexer (22), die so konfiguriert sind, dass sie mit dem Kabelnetz elektrisch verbunden werden;
- eine Verarbeitungseinheit (23), die einen ersten Eingang und einen zweiten Eingang umfasst, wobei der erste Eingang und der zweite Eingang so konfiguriert sind, dass sie jeweils mit dem ersten Multiplexer (21) und mit dem zweiten Multiplexer (22) elektrisch verbunden werden;
wobei die Vorrichtung **dadurch gekennzeichnet ist, dass** sie umfasst:
- eine erste Diode (D1), umfassend eine erste Anode (A1), die so konfiguriert ist, dass sie mit einer Spannungsquelle mit einem ersten Potenzial (V1) verbunden wird, und eine erste Kathode (C1), die so konfiguriert ist, dass sie mit einem Ausgang des ersten Multiplexers (21) und dem ersten Eingang der Verarbeitungseinheit (23) elektrisch verbunden wird; und
- eine zweite Diode (D2), umfassend eine zweite Anode (A2), die so konfiguriert ist, dass sie mit einer Spannungsquelle mit einem zweiten Potenzial (V2) verbunden wird, und eine zweite Kathode (C2), die so konfiguriert ist, dass sie mit einem Ausgang des zweiten Multiplexers (22) und dem zweiten Eingang der Verarbeitungseinheit (23) elektrisch verbunden wird, wobei das zweite Potenzial (V2) von dem ersten Potenzial (V1) verschieden ist;
wobei die Verarbeitungseinheit (23) konfiguriert ist, um:
- eine erste Adresse des ersten Multiplexers (21) und eine zweite Adresse des zweiten Multiplexers (22) auszuwählen;
- eine Potenzialdifferenz zwischen der ersten Kathode (C1) und der zweiten Kathode (C2) zu berechnen; und
- aus der Potenzialdifferenz das Vorliegen eines elektrischen Fehlers im Kabelnetz abzuleiten.

11. Erkennungsvorrichtung (2) nach Anspruch 10, ferner umfassend ein Mittel (24) zum Verbinden von Drähten (13, 14, 15, 16) des Kabelnetzes mit einem einzigen Knoten.

12. Erkennungsvorrichtung (2) nach einem der Ansprüche 10 und 11, wobei die Spannungsquelle eine lokale Quelle oder aus einem elektrischen Netz des Luftfahrzeugs abgeleitet ist.

13. Computerprogrammprodukt, umfassend Befehle, die, wenn das Programm auf einer Verarbeitungseinheit (23) einer Vorrichtung (2) nach einem der Ansprüche 10 bis 12 ausgeführt wird, diese veranlassen, die Schritte E41 bis E43 des Verfahrens nach einem der Ansprüche 1 bis 9 auszuführen.

14. Computerlesbares Speichermedium, auf dem das Computerprogrammprodukt nach Anspruch 13 aufgezeichnet ist.

## Claims

1. A method for detecting an electrical fault in a cable network electrically connecting a first termination (11) and a second termination (12) of an electrical harness (1) of an aircraft, the method comprising the following steps:
E1: connecting the cable network to the channels of a first multiplexer (21) and of a second multiplexer (22) of a device (2) for detecting an electrical fault of the harness (1);
the method being **characterized in that** it further comprises the following steps:
E2: supplying an anode (A1) of a first diode (D1) of the device at a first potential (V1) and an anode (A2) of a second diode (D2) of the device (2) at a second potential (V2) different from the first potential (V1);
the method comprising, at each iteration of a plurality of iterations, the performance of the following steps:
E41: selecting a first address of the first multiplexer (21) and a second address of the second multiplexer (22);
E42: computing a potential difference between a cathode (C1) of the first diode (D1) and a cathode (C2) of the second diode (D2); and
E43: deducing from the potential difference the existence of an electrical fault in the cable network.

2. The method as claimed in claim 1, further comprising a step E3 wherein the addresses of the channels of the first and second multiplexers (21, 22) are configured, each address corresponding to a separate wire (13, 14, 15, 16) of the cable network.

3. The method as claimed in one of claims 1 and 2, further comprising a step E21 wherein wires (13, 14, 15, 16) of the cable network are electrically connected to a single node.

4. The method as claimed in one of claims 1 to 3, further comprising a step E22 of selecting a detection mode of the device (2), for example a short circuit detection mode and/or an open circuit detection mode.

5. The method as claimed in one of claims 1 to 4, wherein the channels of the multiplexers (21, 22) are configured by loading a wiring diagram of the harness (1) recorded in a database.

6. The method as claimed in one of claims 1 to 5, further comprising a step E421 of recording the addresses and the potential difference.

7. The method as claimed in one of claims 1 to 6, wherein the plurality of iterations is at least equal to the number of possible combinations of a channel of the first multiplexer (21) with a channel of the second multiplexer (22).

8. The method as claimed in one of claims 1 to 7, wherein the wires (13, 14, 15, 16) identified as being in an open circuit and/or a short-circuit are displayed, for example on a simplified wiring diagram of the electrical harness (1).

9. The method as claimed in one of claims 1 to 8, wherein the wires (13, 14, 15, 16) identified as being in an open circuit and/or a short circuit are recorded, for example in a file.

10. A device (2) for detecting an electrical fault in a cable network electrically connecting a first termination (11) and a second termination (12) of an electrical harness (1) of an aircraft comprising:
- a connection interface (20) configured to connect the cable network to the detection device (2);
- a first multiplexer (21) and a second multiplexer (22) configured to be electrically connected to the cable network;
- a processing unit (23) comprising a first input and a second input, the first input and the second input being configured to be electrically connected to the first multiplexer (21) and to the second multiplexer (22) respectively;
the device being **characterized in that** it comprises:
- a first diode (D1) comprising a first anode (A1) configured to be connected to a voltage source at a first potential (V1) and a first cathode (C1) configured to be electrically connected to an output of the first multiplexer (21) and the first input of the processing unit (23); and
- a second diode (D2) comprising a second anode (A2) configured to be connected to a voltage source at a second potential (V2) and a second cathode (C2) configured to be electrically connected to an output of the second multiplexer (22) and the second input of the processing unit (23), the second potential (V2) being different from the first potential (V1);
the processing unit (23) being configured to:
- select a first address of the first multiplexer (21) and a second address of the second multiplexer (22);
- compute a potential difference between the first cathode (C1) and the second cathode (C2); and
- deduce from the potential difference the existence of an electrical fault in the cable network.

11. The detection device (2) as claimed in claim 10, further comprising a means (24) for interconnecting wires (13, 14, 15, 16) of the cable network to a single node.

12. The detection device (2) as claimed in one of claims 10 and 11, wherein the voltage source is a local source or tapped from an electrical network of the aircraft.

13. A computer program product comprising instructions which, when the program is executed on a processing unit (23) of a device (2) in accordance with one of claims 10 to 12, lead it to implement the steps E41 to E43 of the method as claimed in one of claims 1 to 9.

14. A storage means readable by a computer, on which the computer program product as claimed in claim 13 is recorded.
